# EUROPÄISCHE PATENTSCHRIFT

(11) **EP 1 742 076 B1**
(45) Veröffentlichungstag und Bekanntmachung des Hinweises auf die Patenterteilung: **17.04.2019**
(21) Anmeldenummer: 06013305.5
(22) Anmeldetag: 28.06.2006
(51) Int. Cl.: G01R 31/02, G01R 31/327, G01R 31/28, G01D 3/08

(54) **Verfahren zum Prüfen von aktiven elektrotechnischen Komponenten**
Method of testing active electrical components
Procédé de vérification de composants électrotechniques actifs

(30) Priorität: 07.07.2005 DE 102005031795
(43) Veröffentlichungstag der Anmeldung: 10.01.2007
(73) Patentinhaber: ROBERT BOSCH GMBH, 70442 Stuttgart (DE)
(72) Erfinder: Garcia, Felipe Cuenca, 35099 Burgwald (DE)

(56) Entgegenhaltungen:
- WO-A-91/13365
- DE-A1- 10 062 333
- DE-A1- 10 155 847
- DE-A1- 19 922 818

## Beschreibung

Die Erfindung betrifft ein Verfahren zum Prüfen von aktiven elektrotechnischen Komponenten, insbesondere zum Einsatz bei einem Heizgerät und/oder einer Heizungsanlage mit einer Regeleinrichtung, nach dem Oberbegriff des Patentanspruches 1. Zum Betreiben eines Heizgerätes und/oder einer Heizungsanlage sind viele verschiedene Funktionskomponenten nötig. Dazu zählen einerseits Aktoren, wie zum Beispiel Umwälzpumpen oder Ölvorwärmer, aber auch einfache Fühlerelemente. Andererseits kommen einige aktive elektrotechnische Komponenten zum Einsatz. Dazu gehören beispielsweise Wasserdruck- oder Abgassensoren. Diese werden mit einer separaten Versorgungsspannung gespeist und geben aktiv ein Signal aus.

Alle aktiven elektrotechnischen Komponenten sind an die Regeleinrichtung angeschlossen, jeweils an einen zugeordneten Eingang an einem Mikroprozessor. Über die Anschlussleitung wird daher ein definierter, in einem vorbestimmten Werteband liegender Spannungswert zum Eingang des Mikroprozessors geleitet. Zu Fehlern kann es möglicherweise kommen, wenn der vorgesehene Steckplatz eines solchen aktiven Bauteils, beispielsweise durch einen Montagefehler, frei bleibt oder das Bauteil defekt ist. Dann tritt in Bezug auf den Spannungswert ein undefinierter Zustand am Eingang des Mikroprozessors für die jeweilige Komponente auf.

Aus der DE 37 41 901 C2 ist ein Verfahren zum Prüfen von Funktionskomponenten eines Fahrzeugheizgerätes bekannt. Allerdings handelt es sich dabei um Aktoren und nicht um aktive elektrotechnische Komponenten. Diese können zum Beispiel von einem Bediener mit einer Einschalteinrichtung einzeln in Betrieb genommen werden, um die Funktion in Einbaulage zu überprüfen.

Weiterhin geht aus der DE 199 22 818 A1 ein Verfahren zum Überprüfen einer Auswerteschaltung hervor, bei der die Ladespannung an einem Kondensator überwacht wird. Außerdem ist aus der DE 103 39 805 A1 ein Verfahren zur Feststellung von Betriebsstörungen eines Relais beschrieben, bei dem ebenfalls der Ladezustand eines Kondensators überwacht wird.

Aus der DE 101 55 847 A1 ist ein Verfahren zur Funktionsüberwachung einer elektrischen Endstufe unter Verwendung eines Transistors bekannt. Während des Betriebes einer Endstufe ist eine Diagnose durch eine nahezu zeitunabhängige Auswertung von Signalpegeln an einem Kondensator möglich. Dieser steht mit seinem Lade- und Entladeverhalten mit einem Transistor in Verbindung.
Aus der DE 100 62 333 A1 ist ein Verfahren zur Diagnose der Ausgangsbeschaltung eines vorzugsweise binärschaltenenden Sensors für die Anwendung bei Kraftfahrzeugen bekannt.

Der Erfindung liegt daher die Aufgabe zu Grunde, ein sicheres Verfahren zum Prüfen des Vorhandenseins von aktiven elektrotechnischen Komponenten, insbesondere zum Einsatz bei einem Heizgerät und/oder einer Heizungsanlage mit einer Regeleinrichtung, zu schaffen.

Erfindungsgemäß wurde dies mit den Merkmalen des Patentanspruches 1 gelöst. Vorteilhafte Weiterbildungen sind den Unteransprüchen zu entnehmen.

Verfahren und Anordnung zum Prüfen von aktiven elektrotechnischen Komponenten sind dadurch gekennzeichnet, dass vom Mikroprozessor über die Anschlussleitung zur Komponente in zyklischen Abständen ein impulsartiges Testsignal in Form einer erhöhten Spannung ausgegeben wird. Ein parallel zur Komponente geschalteter Kondensator wird dadurch aufgeladen und puffert das Signal der Komponente. Im Normalzustand entlädt sich der Kondensator wieder relativ schnell über die Komponente. Dieser Entladevorgang ist spätestens bis zum nächsten impulsartigen Testsignal abgeschlossen. Der Kondensator kann sich aber im Falle einer fehlerhaften Komponente nicht entladen, so dass am zugeordneten Eingang des Mikroprozessors über die Anschlussleitung der Komponente die erhöhte Spannung ansteht.

Das Testsignal ist ein Impuls mit einer gegenüber der Spannung im Normalbetrieb um mindestens 20 Prozent erhöhten Spannung und wird etwa in Abständen von 100 Millisekunden ausgegeben.

Vorzugsweise ist im Normalbetrieb etwa eine Spannung von 0 bis 3,5 Volt und als Testsignal eine erhöhte Spannung von etwa 5 Volt vorgesehen. Wenn die erhöhte Spannung an einem Eingang des Mikroprozessors bei einem der nächsten impulsartigen Testsignale immer noch ansteht, wird eine Wartungsmeldung oder ein Signal als gezielter Hinweis auf den erkannten Fehler ausgegeben. Vorteilhaft ist es, ergänzend in der Anschlussleitung zum Mikroprozessor einen Widerstand mit der Komponente in Reihe zu schalten. Dies dient als Schutzmaßnahme für den Mikroprozessor gegen eventuelle Kurzschlüsse in der Komponente.

Mit dem erfindungsgemäßen Verfahren und der dazu gehörenden Anordnung wird ein sicheres Verfahren zum Prüfen der Funktionsfähigkeit sowie des Vorhandenseins von aktiven, an eine Regeleinrichtung angeschlossenen elektrotechnischen Komponenten, insbesondere zum Einsatz bei einem Heizgerät und/oder einer Heizungsanlage, geschaffen. Die Inbetriebnahme vereinfacht sich durch eindeutige Hinweise auf die Fehlerursache. Undefinierte Zustände treten am Eingang des Mikroprozessors nicht auf.

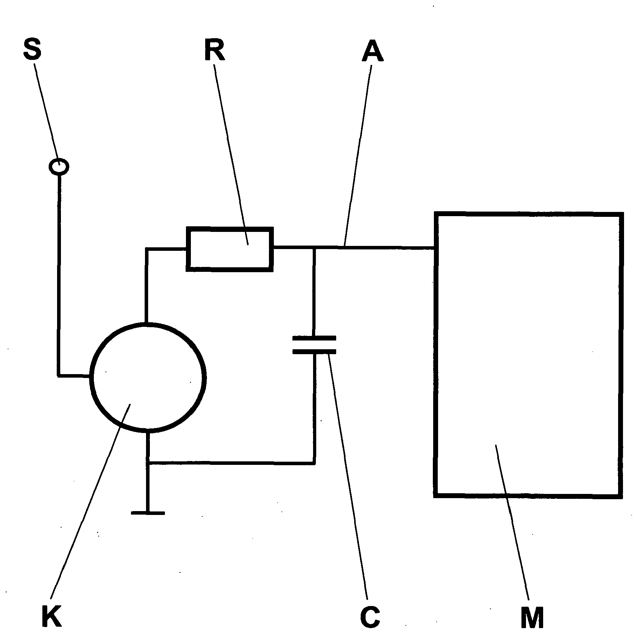

Die Zeichnung stellt ein Ausführungsbeispiel der Erfindung dar und zeigt in einer einzigen Figur ein Schaltungsschema als Anordnung zur Durchführung des erfindungsgemäßen Verfahrens.

Eine aktive elektrotechnische Komponente K mit einer eigenen Spannungsquelle S ist über eine Anschlussleitung A mit einem Mikroprozessor M verbunden. Parallel zur Komponente K ist ein Kondensator C geschaltet und in Reihe mit der Komponente K befindet sich ein Widerstand R als Überspannungsschutz für den Mikroprozessor M in der Anschlussleitung A.

## Patentansprüche

1. Verfahren zum Prüfen des Vorhandenseins von aktiven elektrotechnischen Komponenten (K), insbesondere zum Einsatz bei einem Heizgerät und/oder einer Heizungsanlage mit einer Regeleinrichtung, wobei die Komponenten (K) eine eigene Spannungsversorgung besitzen, aktiv ein Signal ausgeben, an einen zugeordneten Eingang an einem Mikroprozessor angeschlossen sind und über die Anschlussleitung einen Spannungswert zum Eingang des Mikroprozessor (M) leiten,
**dadurch gekennzeichnet, dass** vom Mikroprozessor (M) über die Anschlussleitung (A) zur Komponente (K) in zyklischen Abständen ein impulsartiges Testsignal in Form einer erhöhten Spannung ausgegeben wird und dass ein parallel zur Komponente (K) geschalteter Kondensator (C) dadurch aufgeladen wird, wobei der Kondensator (C) im Normalzustand wieder entladen wird und wobei bei einer fehlerhaften Komponente (K) der Kondensator (C) nicht entladen wird und am Mikroprozessor (M) über die Anschlussleitung (A) der Komponente (K) die erhöhte Spannung ansteht, wobei das Testsignal ein Impuls mit einer gegenüber der Spannung im Normalbetrieb um mindestens 20 Prozent erhöhten Spannung ist.

2. Verfahren nach Anspruch 1,
**dadurch gekennzeichnet, dass** das Testsignal in Form einer erhöhten Spannung etwa in Abständen von 100 Millisekunden ausgegeben wird.

3. Verfahren nach einem der Ansprüche 1 bis 2,
**dadurch gekennzeichnet, dass** etwa eine Spannung von 0 bis 3,5 Volt im Normalbetrieb und als Testsignal einer erhöhte Spannung von etwa 5 Volt vorgesehen ist.

4. Verfahren nach einem der Ansprüche 1 bis 3,
**dadurch gekennzeichnet, dass** eine Wartungsmeldung oder eine Signal ausgegeben wird, wenn die erhöhte Spannung an einem Eingang des Mikroprozessors (M) bei einem der nächsten Testsignale immer noch ansteht.

5. Anordnung, welche ausgebildet ist das Verfahren nach einem der Ansprüche 1 bis 4 auszuführen,
**dadurch gekennzeichnet, dass** eine aktive elektrotechnische Komponente (K) mit einer eigenen Spannungsquelle (S) über eine Anschlussleitung (A) mit einem Mikroprozessor (M) verbunden ist und dass parallel zur Komponente (K) ein Kondensator (C) geschaltet ist.

6. Anordnung nach dem vorhergehenden Anspruch, **gekennzeichnet durch** einen in Reihe mit der Komponente (K) geschalteten Widerstand (R) in der Anschlussleitung (A) zum Mikroprozessor (M).

## Claims

1. Method for checking the presence of active electrotechnical components (K), in particular for use in a heating unit and/or a heating installation with a control device, wherein the components (K) have a separate voltage supply, actively output a signal, are connected to an associated input at a microprocessor and conduct a voltage value via the connection line to the input of the microprocessor (M),
**characterized in that** a pulse-like test signal in the form of an increased voltage is output by the microprocessor (M) via the connection line (A) to the component (K) at cyclical intervals and **in that** a capacitor (C) connected in parallel with the component (K) is charged thereby, wherein the capacitor (C) is discharged again in the normal state and wherein the capacitor (C) is not discharged in the case of a faulty component (K) and the increased voltage is present at the microprocessor (M) via the connection line (A) of the component (K), wherein the test signal is a pulse with a voltage that is increased by at least 20 percent compared to the voltage during normal operation.

2. Method according to Claim 1,
**characterized in that** the test signal in the form of an increased voltage is output approximately at intervals of 100 milliseconds.

3. Method according to either of Claims 1 and 2, **characterized in that** approximately a voltage of 0 to 3.5 volts is provided during normal operation and of approximately 5 volts is provided as the test signal of an increased voltage.

4. Method according to one of Claims 1 to 3, **characterized in that** a maintenance message or a signal is output when the increased voltage is still present at an input of the microprocessor (M) in the case of one of the next test signals.

5. Arrangement, which is designed to carry out the method according to one of Claims 1 to 4,
**characterized in that** an active electrotechnical component (K) with a separate voltage source (S) is connected to a microprocessor (M) via a connection line (A) and **in that** a capacitor (C) is connected in parallel with the component (K).

6. Arrangement according to the preceding claim, **characterized by** a resistor (R) in the connection line (A) to the microprocessor (M), said resistor being connected in series with the component (K).

## Revendications

1. Procédé de contrôle de la présence de composants électrotechniques actifs (K), en particulier pour une utilisation dans un appareil de chauffage et/ou une installation de chauffage comportant un dispositif de réglage, les composants (K) possédant leur propre alimentation en tension, émettant activement un signal, étant raccordés par une entrée associée à un microprocesseur et conduisant par l'intermédiaire de la ligne de raccordement une valeur de tension vers l'entrée du microprocesseur (M),
**caractérisé en ce que** le microprocesseur (M) émet un signal de test de type impulsion sous forme d'une tension accrue par l'intermédiaire de la ligne de raccordement (A) vers le composant (K) par intervalles cycliques, et qu'un condensateur (C) branché parallèlement au composant (K) est ainsi chargé, le condensateur (C) étant redéchargé en état normal et le condensateur (C) n'étant pas déchargé dans le cas d'un composant défectueux (K) et la tension accrue étant appliquée au microprocesseur (M) par l'intermédiaire de la ligne de raccordement (A) du composant (K), le signal de test étant une impulsion avec une tension accrue d'au moins 20 % par rapport à la tension en continnement normal.

2. Procédé selon la revendication 1, **caractérisé en ce que** le signal de test est émis sous forme d'une tension accrue approximativement à des intervalles de 100 millisecondes.

3. Procédé selon une des revendications 1 et 2, **caractérisé en ce qu'**une tension approximative de 0 à 3,5 volts est prévue en fonctionnement normal et en tant que signal de test une tension accrue d'environ 5 volts.

4. Procédé selon une des revendications 1 à 3, **caractérisé en ce qu'**un message d'entretien ou un signal est émis si la tension accrue est toujours appliquée à une entrée du microprocesseur (M) pour un des signaux de test suivants.

5. Dispositif qui est conçu pour exécuter le procédé selon une des revendications 1 à 4, **caractérisé en ce qu'**un composant électrotechnique actif (K) doté de sa propre source de tension (S) est connecté par une ligne de raccordement (A) à un microprocesseur (M) et qu'un condensateur (C) est branché parallèlement au composant (K).

6. Dispositif selon la revendication précédente, **caractérisé par** une résistance (R) branchée en série avec le composant (K) dans la ligne de raccordement (A) au microprocesseur (M).
